# EUROPÄISCHE PATENTANMELDUNG

(11) **EP 2 148 363 A2**
(43) Veröffentlichungstag der Anmeldung: **27.01.2010**
(21) Anmeldenummer: 09008710.7
(22) Anmeldetag: 03.07.2009
(51) Int. Cl.: H01L 21/60, B23K 35/02

(54) **Edelmetall basiertes Verbindungsmittel mit einem Feststoffanteil und einem Flüssiganteil und Verwendungsverfahren hierzu**

(30) Priorität: 26.07.2008 DE 102008034953
(71) Anmelder: Semikron Elektronik GmbH & Co. KG Patentabteilung, 90431 Nürnberg (DE)
(72) Erfinder: Fey, Tobias, 91058 Erlangen (DE); Göbl, Christian, 90441 Nürnberg (DE); Braml, Heiko, 91346 Wiesenttal (DE); Hermann, Ulrich, 90408 Nürnberg (DE)

(57) **Zusammenfassung**

Die Erfindung beschreibt ein Edelmetallverbindungsmittel mit einem Feststoffanteil und einem Flüssiganteil mit einem zugeordneten Mischungsverhältnis in Volumenprozent von 99,5:0,5 bis 80:20 der beiden. Hierbei weist der Feststoffanteil einen Volumenanteil an einer ersten Komponente Silber von 60% bis 95% und einen Volumenanteil an einer zweiten Komponente Silberoxid von 5% bis 40% auf. Die jeweiligen Komponenten des Feststoffanteils liegen als Partikel mit Längenabmessungen zwischen 50nm und 20µm vor. Die Verwendung des Edelmetallverbindungsmittels dient der Ausbildung einer stoffschlüssigen Verbindung zweier metallischer Verbindungspartner, wobei die Ausbildung der Verbindung durch Wärmeeinwirkung erfolgt.

## Beschreibung

Die Erfindung beschreibt ein Edelmetallverbindungsmittel sowie ein Verfahren zu dessen Verwendung, wodurch zwei Verbindungspartner stoffschlüssig und elektrisch leitend miteinander verbunden werden.

Beispielhaft gemäß der DE 34 14 065 C2 oder der DE 10 2005 058 794 A1 ist es bekannt zwei Verbindungspartner mit jeweils einer Edelmetalloberfläche stoffschlüssig zu verbinden und hierzu eine Verbindungsmittel zu verwenden, welches aus Silberpartikeln besteht, die mit einer Flüssigkeit, häufig Terpiniol, vermischt werden. Es ist weiterhin bekannt, dass die zu verbindenden Oberflächen zumindest überwiegend aus Edelmetall bestehen müssen.

Zur Ausbildung der Verbindung wird die Mischung aus Silber und Terpiniol auf eine der beiden zu verbindenden Oberflächen aufgetragen, der zweite Verbindungspartner angeordnet und die gesamte Anordnung mit Druck in der Größenordnung von 40MPa und bei einer Temperatur von bevorzugt mindestens 250°C beaufschlagt. Die hierdurch entstehende elektrisch leitende stoffschlüssige Verbindung weist eine hohe Festigkeit und Langzeitstabilität auf.

Nachteilig an den genannten Verbindungen ist, dass der hohe Druck nicht für jeden beliebigen Verbindungspartner anwendbar ist, oder zumindest in der Anwendung hohe Anforderungen stellt um beispielhaft bei der Verbindung eines Metalls mit einem Silizumchip diesen nicht zu beschädigen.

Der Erfindung liegt die Aufgabe zugrunde ein Edelmetallverbindungsmittel und ein Verfahren zu dessen Verwendung vorzustellen, bei dem die Druckbeaufschlagung um mindestens eine Größenordnung verringert werden kann oder wobei auch vollständig auf diese Druckbeaufschlagung verzichtet werden kann und wobei die notwendige Temperatur zur Ausbildung der Verbindung ebenfalls reduziert werden kann.

Diese Aufgabe wird erfindungsgemäß gelöst, durch ein Edelmetallverbindungsmittel mit den Merkmalen des Anspruchs 1, sowie durch ein zugeordnetes Verwendungsverfahren nach Anspruch 6. Bevorzugte Ausführungsformen sind in den abhängigen Ansprüchen beschrieben.

Ausgangspunkt der Erfindung sind bekannte Edelmetallverbindungsmittel bestehend aus einer Mischung aus Silberpartikeln und einem Lösungsmittel, vorzugsweise Terpiniol. Das erfindungsgemäße Edelmetallverbindungsmittel weist ebenfalls einem Feststoffanteil und einem Flüssiganteil auf, wobei diese in einem Verhältnis in Volumenprozent von 99,5:0,5 bis 80:20 von Feststoffanteil zu Flüssiganteil gemischt sind. Der Feststoffanteil seinerseits weist mindestens zwei Komponenten auf, wovon die erste wie aus dem Stand der Technik bekannt aus Silberpartikeln besteht und einen Volumenanteil am Feststoffanteil von 60% bis 95% aufweist. Die zweite Komponente ist Silberoxid mit einem Volumenanteil am Feststoffanteil von 5% bis 40%. Beide Komponenten des Feststoffanteils liegen als Partikel mit Längenabmessungen zwischen 50nm und 20µm vor.

Es kann bevorzugt sein, wenn der Feststoffanteil neben den beiden genannten Komponenten noch mindestens eine weitere Komponente mit einem Volumenanteil von weniger als 10% aufweist. Diese weitere Komponente sind vorzugsweise Metallpartikel der oben genannten Größe aus Kupfer, Gold oder Platin. Alternativ kann diese weitere Komponente auch ein Element der 3. Hauptgruppe (Borgruppe) des Periodensystems sein oder eine Mischung dieser genannten Stoffen. Es ist ebenso vorteilhaft zumindest die Silberpartikel oder auch die Partikel der weiteren Komponente des Feststoffanteils mit einer organischen Passivierungsschicht zu überziehen. Hierdurch wird beispielhaft eine ungewollte Reaktion des Edelmetallverbindungsmittels, speziell des Silbers, mit Luftsauerstoff vermieden.

Als Flüssiganteil bietet sich neben dem bekannten und bevorzugten Terpiniol alternativ eine Lösung aus Polyvinylacetat oder Polyvinylbutyral mit einem Lösungsmittel an. Hierbei ist ein bevorzugtes Lösungsmittel für Polyvinylacetat oder Polyvinylbutyral ein Alkohol, ein Keton oder ein Ester. Ebenfalls alternativ kann Polyvinylalkohol oder dessen teilverseiften Kopoloymeren in einer wässrigen Lösung verwendet werden.

Das erfindungsgemäße Verfahren zur Verwendung eines derartigen Edelmetallverbindungsmittel weist die folgenden wesentlichen Schritte auf:
- Anordnung des Edelmetallverbindungsmittels in Form einer Schicht auf einer ersten metallischen Oberfläche eines ersten Verbindungspartners. Hierbei ist es natürlich bevorzugt wenn diese Oberfläche einen Edelmetallanteil von mehr als 90% aufweist. Zur Anordnung dieser Schicht haben sich grundsätzlich bekannte Verfahren, wie Sieb- oder Schablonendruckverfahren oder auch ein Dispensverfahrens als besonders zweckmäßig erwiesen. Speziell das Dispersionsverfahren eignet sich besonders bei Edelmetallverbindungsmitteln mit hohem Flüssigkeitsanteil.
- In einem fakultativen Schritt kann es bevorzugt sein die Schicht des Edelmetallverbinders mit einem Plasma zu beaufschlagen und diese somit zu aktivieren. Hierbei eignet sich besonders ein Stickstoff- oder Formiergasplasma, wobei auch eine sauerstoffhaltige Umgebung nicht nachteilig ist.
- Anordnung eines zweiten Verbindungspartners mit einer zweiten Oberfläche auf dieser Schicht, wobei diese Oberfläche bevorzugt ebenfalls einen Edelmetallanteil von mehr als 90% aufweist.
- Temperaturbeaufschlagung, bevorzugt mittels Induktionsverfahren oder mittels Mikrowellenanregung, der Schicht mit einer Temperatur zwischen 170°C und 230°C wodurch eine elektrisch leitende stoffschlüssige Verbindung der beiden Verbindungspartner entsteht. Bei dieser Temperaturbeaufschlagung zerfällt das Silberoxid durch Thermolyse, wodurch der entstehende Sauerstoff die organischen Passivierungsschichten beispielhaft um die Silberpartikel zersetzt, wodurch diese sich per Festkörperdiffusionsprozess miteinander verbinden.
- In einem weiteren fakultativen zeitlich mit der Temperaturbeaufschlagung zusammenfallenden Verfahrensschritt werden die beiden Verbindungspartner und die dazwischen angeordnete Schicht des Edelmetallverbindungsmittels mit Druck beaufschlagt, wobei hier allerdings eine Druckbeaufschlagung mit weniger als 5MPa ausreichend ist.

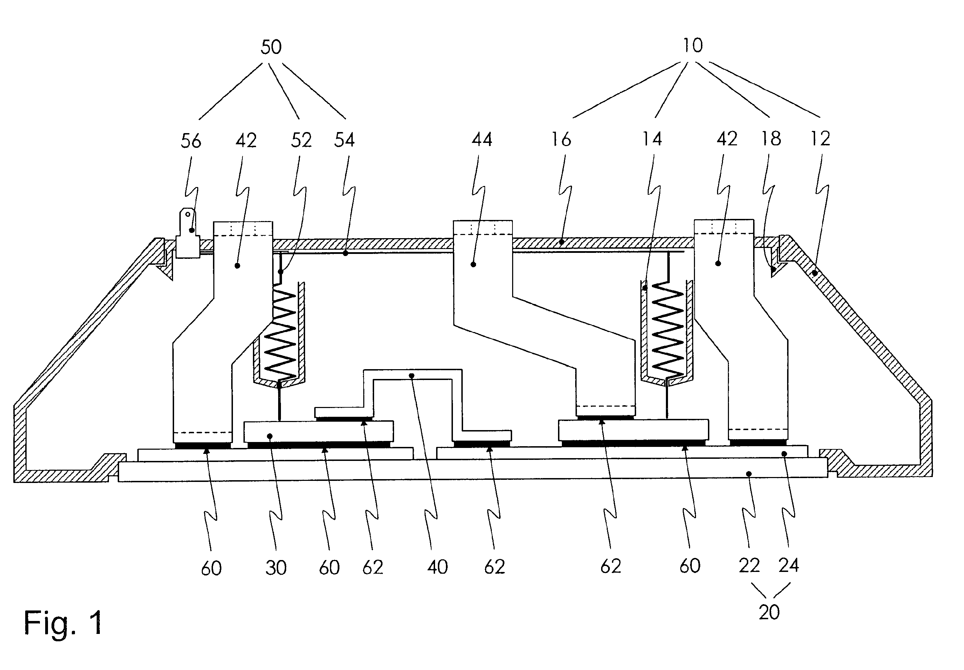

Besonders bevorzugte Weiterbildungen der erfindungsgemäßen Verwendung dieses Edelmetallverbindungsmittel sind in der jeweiligen Beschreibung des folgenden Ausführungsbeispiels genannt. Die erfinderische Lösung wird zudem an Hand der Fig. 1 weiter erläutert.

Fig. 1 zeigt ein Leistungshalbleitermodul im Längsschnitt hergestellt mittels der erfindungsgemäßen Verwendung des genannten Edelmetallverbindungsmittels. Dargestellt ist hier ein Substrat (20), vorzugsweise bestehend aus einer Industriekeramik (22) wie Aluminiumoxid oder Aluminiumnitrid. Hierauf sind mittels bekannter Verfahren, wie beispielhaft des DCB- Verfahrens metallische Schichten auf einer oder beiden Hauptflächen der Keramik (22) aufgebracht. Die dem Inneren des Leistungshalbleitermoduls angeordnete metallische Schicht ist hierbei in sich strukturiert und bildet einzelne elektrisch isolierte Leiterbahnen (24).

Auf diesen Leiterbahnen (24) sind zwei Leistungshalbleiterbauelemente (30), beispielhaft Leistungsthyristoren, Leistungstransistoren und / oder Leistungsdioden, angeordnet. Die elektrisch leitende Verbindung zwischen den Leiterbahnen (24) und den Leistungshalbleiterbauelementen (30) besteht aus der erfindungsgemäßen Edelmetallverbindungsmittel (60, 62) mit einer Schichtdicke von ca. 50µm nach seiner Verwendung, bei der ein wesentlicher Teil des Flüssigkeitsanteils durch die Temperaturbeaufschlagung ausgetrieben ist.

Zur schaltungsgerechten Verbindung der Leistungshalbleiterbauelemente (30) dienen metallische Verbindungselemente (40), die mittels Stanz- Biegetechniken hergestellt wurden. Hier wird die dem Substrat (20) abgewandte Leistungskontaktfläche eines Leistungshalbleiterbauelements (30) mit einer Leiterbahn (24) des Substrats (20) verbunden. Ebenso sind Verbindungen zwischen mindestens zwei Leistungshalbleiterbauelementen (30) oder zwischen mindestens zwei Leiterbahnen (24) möglich, wenn die schaltungsgerechte Verbindung dies erfordert. Die elektrisch leitenden Verbindungen (60, 62) dieser Verbindungselemente (40) mit Leistungshalbleiterbauelementen (30) und / oder Leiterbahnen (24) sind ebenfalls mittels der erfindungsgemäßen Verwendung des Edelmetallverbindungsmittels hergestellt.

Die Lastanschlusselemente (42, 44) bestehen ebenso wie die Verbindungselemente (40) aus Stanz- Biegeelementen. Hier dargestellt sind zwei Lastanschlusselemente (42), die von Leiterbahnen (24) nach außen führen sowie ein Lastanschlusselemente (44), das von einem Halbleiterbauelement (30) nach außen führt. Diese Lastanschlusselemente (42, 44) dienen somit der externen Kontaktierung. Auch die elektrisch leitenden Verbindungen (60, 62) dieser Lastanschlusselemente (42, 44) mit Leistungshalbleiterbauelementen (30) und / oder Leiterbahnen (24) erfolgt gemäß der erfindungsgemäßen Verwendung des Edelmetallverbindungsmittels.

Zu rationellen Herstellung des Verbundes aus Substrat (20), Leistungshalbleiterbauelementen (30), Verbindungs- (40) und Lastanschlusselementen (42, 44) können alle diese Element sowie das notwendige Edelmetallverbindungsmittel zueinander angeordnet werden und anschließend mittels des erfindungsgemäßen Verfahrens die elektrisch leitenden stoffschlüssigen Verbindungen hergestellt werden. Der wesentlich Vorteil gegenüber dem Stand der Technik ist hier, dass auf eine Druckeinleitung verzichtet werden kann, wodurch auch die Lastanschlusselemente einfach zu verbinden sind, da hier eine Druckeinleitung technisch nur schwierig realisierbar ist.

Anschießend wird ein erstes Gehäuseteil (12) derart angeordnet, dass es das Substrat (20) umschließt und überdeckt. Das Gehäuseteil (12) selbst weist Führungen (14) auf, in denen die Kontaktfedern (52) der Hilfsanschlüsse (50) angeordnet und in ihrer Position fixiert sind. Ein Deckel (16), als weiterer Teil des Gehäuses (10), weist an seiner dem Gehäuseinneren zugewandten Seite Verbindungsbahnen (54) auf, Diese Verbindungsbahnen (54) weisen ein erstes Ende auf und sind dort mit jeweiligen Metallformteilen (56) verbunden, die den Deckel (16) durchdringen und an der Außenseite als Stecker ausgebildet sind und der Verbindung der Hilfssignale dienen. Die als Kontaktfeder (52) ausgebildeten innern Abschnitte der Hilfsanschlüsse (50) enden auf dem jeweils zweiten Ende der Verbindungsbahnen (54) des Deckels (16). Um diese Verbindung wie auch die Verbindung mit den Hilfskontaktflächen der Leistungshalbleiterbauelemente (30) sicher zu stellen werden die Kontaktfeder (52) durch den Gehäusedeckel (16) mit Druck beaufschlagt. Die wird durch Schnapp-Rastverbindungen (18) des Deckels (16) mit dem ersten Gehäuseteil (12) erreicht.

## Patentansprüche

1. Edelmetallverbindungsmittel mit einem Feststoffanteil und einem Flüssiganteil mit einem zugeordneten Mischungsverhältnis in Volumenprozent von 99,5:0,5 bis 80:20 der beiden,
wobei der Feststoffanteil einen Volumenanteil an einer ersten Komponente Silber von 60% bis 95% und einen Volumenanteil an einer zweiten Komponente Silberoxid von 5% bis 40% aufweist und wobei die jeweiligen Komponenten des Feststoffanteils als Partikel mit Längenabmessungen zwischen 50nm und 20µm vorliegen.

2. Edelmetallverbindungsmittel nach Anspruch 1,
wobei der Feststoffanteil mindestens eine weitere Komponente mit einem Volumenanteil von weniger als 10% aufweist.

3. Edelmetallverbindungsmittel nach Anspruch 2,
wobei die weitere Komponente Kupfer, Gold, Platin, ein Element der 3. Hauptgruppe des Periodensystems oder eine Mischung hieraus ist.

4. Edelmetallverbindungsmittel nach Anspruch 1,
wobei der Flüssiganteil Terpiniol, eine Lösung aus Polyvinylacetat, Polyvinylbutyral, Polyvinylalkohol oder einem teilverseiften Kopoloymer des Polyvinylalkohols mit einem geeigneten Lösungsmittel ist.

5. Edelmetallverbindungsmittel nach Anspruch 4,
wobei das Lösungsmittel für Polyvinylacetat oder Polyvinylbutyral ein Alkohol, ein Keton oder ein Ester ist und für Poylvinylalkohol oder dessen Kopolymer Wasser ist.

6. Edelmetallverbindungsmittel nach Anspruch 1,
wobei die Partikel mindestens einer Komponente des Feststoffanteils mit einer organischen Passivierungsschicht überzogen sind.

7. Verfahren zur Verwendung eines Edelmetallverbindungsmittel nach einem der Ansprüche 1 bis 6 **gekennzeichnet durch** die folgenden Schritte:
• Anordnung des Edelmetallverbindungsmittels in Form einer Schicht auf einer ersten metallischen Oberfläche eines ersten Verbindungspartners;
• Anordnung eines zweiten Verbindungspartners mit einer zweiten Oberfläche auf dieser Schicht;
• Temperaturbeaufschlagung der Schicht mit einer Temperatur zwischen 170°C und 230°C wodurch eine elektrisch leitende stoffschlüssige Verbindung der beiden Verbindungspartner entsteht.

8. Verfahren nach Anspruch 7,
wobei die Temperaturbeaufschlagung mittels Induktionsverfahren oder mittels Mikrowellenanregung erfolgt.

9. Verfahren nach Anspruch 7,
wobei zusätzlich zur Temperaturbeaufschlagung eine Druckbeaufschlagung der beiden Verbindungspartner mit dazwischen angeordneter Schicht des Edelmetallverbindungsmittels mit weniger als 5MPa erfolgt.

10. Verfahren nach Anspruch 7,
wobei die metallische Oberfläche einen Edelmetallanteil von mehr als 90% aufweist.

11. Verfahren nach Anspruch 7,
wobei durch Thermolyse das Silberoxid zerfällt und somit organische Passivierungsschichten von Partikeln des Edelmetallverbindungsmittels zersetzt werden.

12. Verfahren nach Anspruch 7,
wobei vor Anordnung des zweiten Verbindungspartners die Schicht des Edelmetallverbindungsmittels mit einem Plasma beaufschlagt und somit aktiviert wird.

13. Verfahren nach Anspruch 12,
wobei ein Stickstoff- oder Formiergasplasma verwendet wird.

14. Verfahren nach Anspruch 7,
wobei die Schicht des Edelmetallverbindungsmittels mittels eines Sieb- oder Schablonendruckverfahrens ausgebildet wird.

15. Verfahren nach Anspruch 7,
wobei die Schicht des Edelmetallverbindungsmittels mittels eines Dispensverfahrens ausgebildet wird.
